Europäisches Patentamt

European Patent Office

Office européen des brevets

(11) Publication number: **0 306 890**
**A1**

# EUROPEAN PATENT APPLICATION

(21) Application number: 88114504.9

(51) Int. Cl.4: **H01L 23/12 , H01L 25/04**

(22) Date of filing: 06.09.88

(30) Priority: **11.09.87 US 96103**

(43) Date of publication of application:
**15.03.89 Bulletin 89/11**

(84) Designated Contracting States:
**DE FR GB IT NL**

(71) Applicant: **FAIRCHILD SEMICONDUCTOR CORPORATION**
**2900 Semiconductor Drive**
**Santa Clara California 95052(US)**

(72) Inventor: **Phy, William S.**
**25616 Moody Road**
**Los Altos Hills California 94022(US)**

(74) Representative: **Dipl.-Ing. H. Marsch Dipl.-Ing.**
**K. Sparing Dipl.-Phys.Dr. W.H. Röhl**
**Patentanwälte**
**Rethelstrasse 123**
**D-4000 Düsseldorf 1(DE)**

(54) A semiconductor module having active devices disposed in substrate cavities.

(57) A hybrid integrated circuit module (4) comprising a silicon substrate (8) having a plurality of cavities (12) formed therein. The cavities are formed so that active devices (14) disposed in the cavities have upper surfaces (32) that are substantially co-planar with an upper layer of conductors (20) disposed on the upper surface of the substrate (18). The terminals of the active device may be connected to the upper layer of conductors using extremely short and straight leads. The semiconductor module is formed by etching cavities into the silicon substrate and then inserting plugs into the cavities. The substrate is planarized, and alternating layers of dielectric and patterned metal conductors are formed on the planar surface. The layers above the plugs are removed to expose the plugs, and then the plugs are removed. The active devices are inserted into the cavities, and the terminals of the active devices are connected to the conductors on the upper metal layer.

FIG._1.

# A SEMICONDUCTOR MODULE HAVING ACTIVE DEVICES DISPOSED IN SUBSTRATE CAVITIES

## BACKGROUND OF THE INVENTION

### 1. Field of the Invention

This invention relates to semiconductor modules and, more particularly, to a hybrid integrated circuit module having active devices mounted in cavities etched in a silicon substrate.

### 2. Description of the Relevant Art

Conventional modular or hybrid integrated circuit modules typically comprise thin or thick film circuits of conductors, resistors, and sometimes capacitors disposed on a glass reinforced organic or ceramic substrate. The circuits are combined with monolithic active devices and/or I.C.'s, which are bonded to the conductor pattern on the substrate. One bonding method involves mounting the active devices face-up on the substrate, which creates an irregular non-planar structure, and then extending leads, such as wires or metal films, from the terminals of the active devices to the conductors on the substrate. However, the length of the connecting leads affect signal propagation speed, and the inevitable bends in the leads from the terminals in the active device to the conductors on the substrate, as a result of the non-planar configuration, cause excessive dissipation of high frequency signals. The effect is especially severe with today's advanced ECL devices. Additionally, the active devices, being made of silicon, have coefficients of expansion that differ significantly from the ceramic substrate. This causes thermal stress during operation. Finally, the ceramic substrate is a poor heat conductor which makes it more difficult to properly cool the active devices during operation.

Another method of mounting the active devices to the substrate involves inverting the active device chip and bonding the terminals thereof directly to the conductor pattern on the substrate. However, this "flip-chip" method also suffers from the disadvantage of being a non-planar structure, and since the bonding joints are under the chip, they cannot easily be inspected.

## SUMMARY OF THE INVENTION

The present invention is directed to a hybrid integrated circuit module and a process for making it. The integrated circuit module provides improved heat dissipation, minimizes thermal stress, and is formed as a planar structure. The latter feature eliminates the necessity of long, bending wire or film leads between the active devices and the conductors on the substrate.

In one embodiment of the present invention, an active device is disposed in a cavity formed in an upper surface of a silicon substrate. The silicon substrate helps to conduct heat away from the active device and, since the device and substrate are formed of the same material, thermal stress is minimized as the device and substrate expand and contract relative to each other. When disposed in the cavity, the active device has an upper surface that is substantially co-planar with the upper layer of conductors disposed on the upper surface of the substrate. Thus, the terminals of the active device may be connected to the upper layer of conductors using extremely short and straight leads, thus minimizing signal path length and dissipation.

The method of fabricating the semiconductor module according to the present invention involves etching cavities in the silicon substrate and inserting plugs into the cavities. The substrate then is planarized, and alternating layers of dielectric and patterned conductors are formed on the planar surface. The layers above the plugs are removed to expose the plugs, and then the plugs are removed. The active devices are inserted into the cavities, and the terminals of the active devices are connected to the conductors on the upper metal layer.

## BRIEF DESCRIPTION OF THE DRAWINGS

Fig. 1 is a cross-sectional view of a hybrid integrated circuit module in accordance with a preferred embodiment of the present invention.

Figs. 2-9 illustrate the steps according to one embodiment of the present invention for forming the device of Fig. 1.

## DETAILED DESCRIPTION OF THE PREFERRED EMBODIMENTS

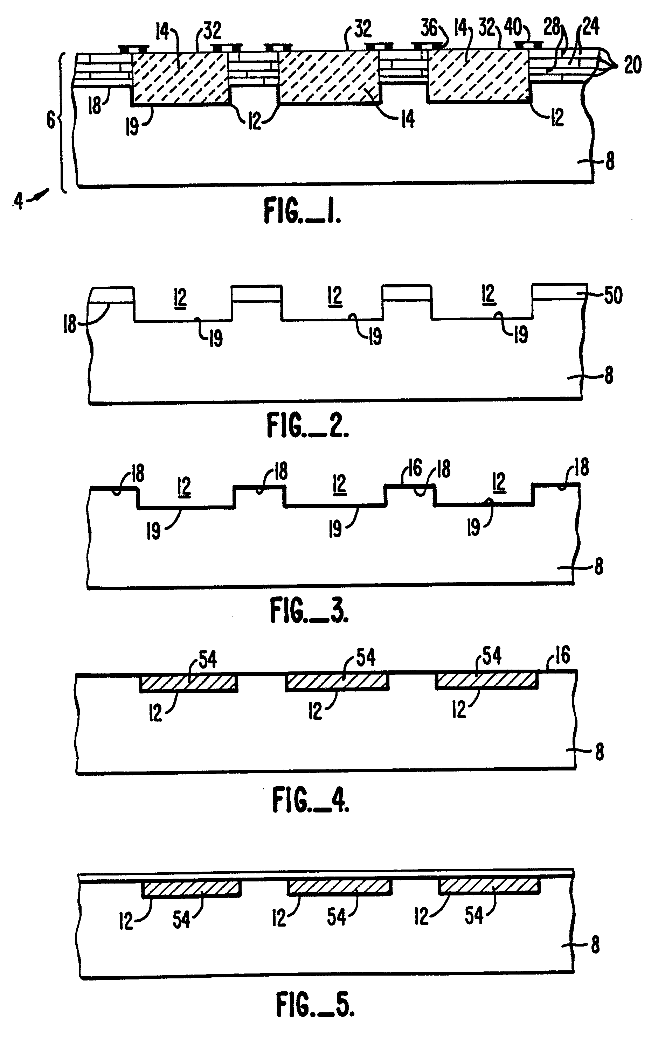

Fig. 1 is a cross-sectional view of a semiconductor module 4 in accordance with the preferred embodiment of the present invention. As shown therein, module 4 comprises a base 6 having a plurality of cavities 12 formed therein. An active device 14 is mounted in each cavity 12. Active device 14 may be any electrical or electronic element capable of controlling voltages or currents to produce gain or switching action in a circuit. In this embodiment, active device 14 is an integrated circuit die or chip. Base 6 includes a silicon substrate 8. A first metal layer 16 is disposed on substrate 8 and extends continuously along the upper surface 18 of substrate 8 and on the interior surface 19 of each cavity 12. First metal layer 16 may be used as a ground plane, and it additionally provides a thermal connection between active devices 14 and substrate 8. Base 6 further comprises one or more, e.g., four, patterned second metal layers 20 spaced apart by dielectric layers 24. Second metal layers 20 together form the module tracking conductors which are interconnected by solid post vias 28. An upper surface 32 of each active device 14 is substantially co-planar with the uppermost second metal layer 20, and terminals 36 of each active device 14 are connected to the uppermost second metal layer 20 through very short and straight leads 40.

The steps used for forming the device shown in Fig. 1 are illustrated in Figs. 2-9. First, as shown in Fig. 2, silicon substrate 8 is covered with a layer of photoresist 50, and the photoresist then is removed above the areas of substrate 8 where the cavities 12 are to be formed. Substrate 8 then is etched to form apertures 12. Preferably, a well known anisotropic etching technique, such as plasma or reactive ion bombardment, is used for this purpose. Liquid etching also may be performed by immersion of substrate 8 into a sodium hydroxide solution at approximately 60° C. After the etching is complete, photoresist 50 is removed using conventional techniques.

The next step, illustrated in Fig. 3, is to form the continuous first metal layer 16 by vacuum deposition using thin film techniques, such as filament E-beam or sputtering, on the upper surface 18 of substrate 8 and on the interior surface 19 of cavities. First metal layer 12 typically comprises copper or aluminum which is approximately 1 micron thick.

Next, as shown in Fig. 4, plugs 54 of substantially the same dimension as cavities 12 are inserted into the cavities and bonded to the interior surfaces 19 by a low-melting temperature inorganic media, such as indium. Plugs 54 may consist of silicon or some other readily machineable inorganic material, such as alumina ($Al_2O_3$) or mullite ($3Al_2O_3.2SiO_2$). Plugs 54 restore an approximation of a planar surface to substrate 8.

The next step, illustrated in Fig. 5, is to form a dielectric layer 24 over substrate 8 and plugs 54. Dielectric layer 24 acts as an insulator and a planarizing layer. Preferably, dielectric layer 24 is formed by spinning an organic dielectric, such as a polyimide, to form a layer of approximately 1-2 mil. thick. The dielectric then is cured in a non-oxidizing ambient atmosphere, such as nitrogen.

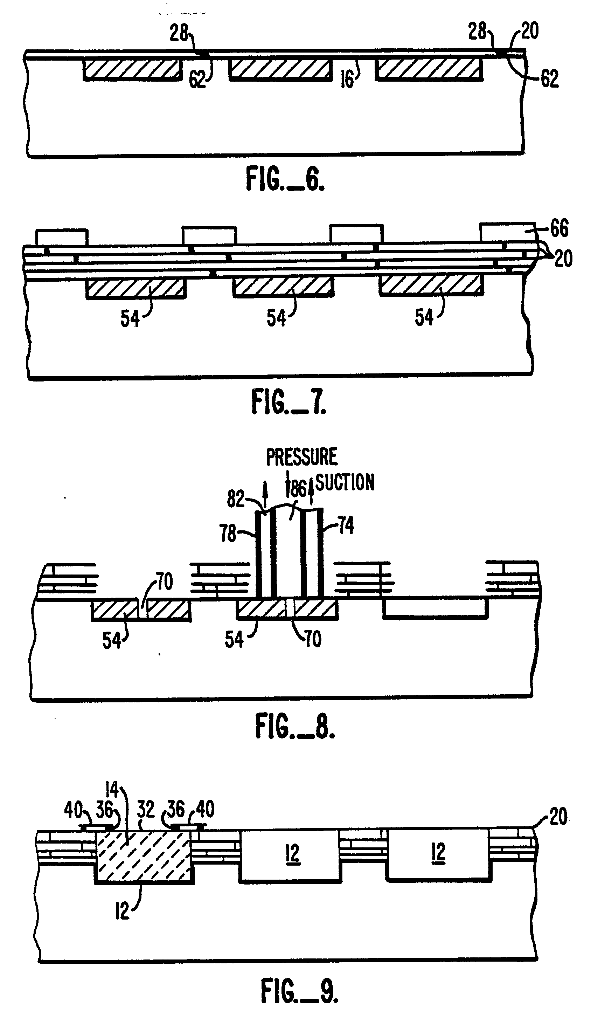

The next step, illustrated in Fig. 6, is to etch openings 62 into dielectric layer 24, using well known photolithographic techniques followed by wet or dry etches, and then to deposit and pattern a second copper metal layer 20 on dielectric layer 24 for forming tracking conductors. The deposited metal flows into openings 62 and forms the solid post vias 28 which connect selected tracks of the patterned second metal layer 20 to first metal layer 16. The process may be repeated by alternating layers of dielectric and metal, as illustrated in Fig. 7, for providing the desired conductor tracks and interconnections. Afterward, a layer of photoresist 66 is deposited on the uppermost metal layer 20, and the portions of photoresist layer 66 above plugs 54 are removed.

The next step, illustrated in Fig. 8, is to etch the dielectric layers 24 above each plug 54 for exposing the plugs so that they may be removed. Removal of plugs 54 preferably is accomplished by drilling an opening 70 in each plug 54 and heating substrate 8 to a temperature sufficient to melt the medium affixing each plug 54 to substrate 8. A tool 74 then may be used to effect removal of each plug 54. Tool 74 comprises a nozzle 78 having an annular vacuum passage 82 which is positioned substantially near the periphery of plug 54. Nozzle 78 further includes a pressure passage 86 for supplying a gas under pressure to opening 70 in plug 54. The vacuum produced in annular vacuum passage 82 is sufficient to attach nozzle 78 to plug 54, while the pressurized gas flowing through pressure passage 86 and through opening 70 in plug 54 is sufficient to dislodge plug 54 from substrate 8.

Finally, as shown in Fig. 9, an active device 14, such as an integrated circuit, is placed within each cavity 12. Leads 40 then are affixed between terminals 36 and upper metal layer 20, preferably by tape bonding. The upper surface 32 of active device 14 is substantially co-planar with the uppermost metal layer 20, so leads 40 are formed as short as possible and do not have to bend as they extend from terminals 36 of active device 14 to uppermost metal layer 20.

While the above is a complete description of a preferred embodiment of the present invention, various modifications are obvious to those of ordinary skill in the art. For example, first metal layer 12 may be omitted, and fewer or more second metal layers 20 may be formed, as the circumstances require. Substrate 8 also may contain active regions if yield is not negatively impacted. Consequently, the scope of the invention should not be limited except as properly described in the claims.

## Claims

1. A semiconductor module comprising:
a base having a cavity formed therein; and
an active device disposed in the cavity, the active device having an upper surface that is generally co-planar with an upper surface of the base.

2. The module according to claim 1 wherein the base comprises a silicon substrate.

3. The module according to claim 2 wherein the size of the cavities is substantially the same as the size of the active device.

4. The module according to claim 3 wherein the base further comprises:
a planarizing layer disposed on the substrate; and
a metal layer disposed on the planarizing layer, the metal layer being substantially co-planar with the upper surface of the active device, and the upper surface of the active device being connected to the metal layer.

5. A semiconductor module comprising:
a silicon substrate having a plurality of cavities formed therein;
a first metal layer continuously disposed on an upper surface of the substrate and on an interior surface of each cavity;
a planarizing layer disposed on the first metal layer and having openings generally aligned with the cavities;
a patterned second metal layer disposed on the planarizing layer; and
an active device disposed in a cavity, the active device having an upper surface that is substantially co-planar with the second metal layer and being connected thereto.

6. The module according to claim 5 wherein the planarizing layer is formed of a dielectric material.

7. The module according to claim 6 wherein there are a plurality of second metal layers, each second metal layer being patterned for forming conductor tracks.

8. The module according to claim 8 further comprising a dielectric layer disposed between each second metal layer.

9. The module according to claim 7 further comprising a metal via disposed between and connected to two second metal layers.

10. The module according to claim 9 wherein the active device is in an integrated circuit.

FIG._1.

FIG._2.

FIG._3.

FIG._4.

FIG._5.

**FIG._6.**

**FIG._7.**

**FIG._8.**

**FIG._9.**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 222 144 (FUJITSU)<br>* Figure 7; claims 1,3,6,8; column 4, lines 7-9,21-40 * | 1-3 | H 01 L 23/12<br>H 01 L 25/04 |
| A | | 4,5,7-10 | |
| X | DE-A-2 704 373 (HITACHI)<br>* Figure 2e; claims 1,6,12 * | 1,2 | |
| A | | 4,6,10 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 30-11-1988 | DE RAEVE R.A.L. |